# EUROPEAN PATENT APPLICATION

(11) **EP 4 575 922 A1**
(43) Date of publication of application: **25.06.2025**
(21) Application number: 24221371.8
(22) Date of filing: 19.12.2024
(51) Int. Cl.: G06N 10/40

(54) **FREQUENCY PLACEMENT OF QUBIT READOUT RESONATORS**

(30) Priority: 19.12.2023 FI 20236399
(71) Applicant: IQM Finland Oy, 02150 Espoo (FI)
(72) Inventor: LANDRA, Alessandro, 02150 Espoo (FI); OCKELOEN-KORPPI, Caspar, 02150 Espoo (FI); JULIUSSON, Kristinn, 02150 Espoo (FI); GUTHRIE, Andrew, 02150 Espoo (FI)
(74) Representative: Berggren Oy

(57) **Abstract**

A device includes: a plurality of qubits arranged in a two-dimensional topology and a plurality of readout resonators. Each readout resonator of a first readout resonator group is arranged to electromagnetically couple to a respective qubit of a first qubit group. Each readout resonator of a second readout resonator group is arranged to electromagnetically couple to a respective qubit of a second qubit group. Resonance frequencies of the readout resonators of the first readout resonator group comprise resonance frequencies from a first resonance frequency band and resonance frequencies of the readout resonators of the second readout resonator group comprise resonance frequencies from a second resonance frequency band, and resonance frequencies of the readout resonators of the first readout resonator group and resonance frequencies of the readout resonators of the second readout resonator group are permuted at least for the nearest neighbors.

## Description

### FIELD OF THE INVENTION

The invention is generally related to the field of quantum computing. In particular, the invention is related to frequency placement for qubit readout resonators.

### BACKGROUND OF THE INVENTION

Large-scale quantum computers have the potential to provide fast solutions to certain classes of difficult problems. Multiple challenges in the design and implementation of quantum architecture to control, program and maintain quantum hardware impede the realization of large-scale quantum computing.

A quantum computing device, also referred to as a quantum computer, uses quantum mechanical phenomena, such as superposition and entanglement, to perform required quantum computing operations. Unlike a conventional computer that manipulates information in the form of bits (e.g., "1" or "0"), the quantum computer manipulates information using qubits. A qubit may refer not only to a basic unit of quantum information but also to a quantum device that is used to store one or more qubits of information (e.g., the superposition of "0" and "1").

The quantum computer may be implemented based on superconducting circuits comprising superconducting qubits and/or resonators. Tunable interaction between the superconducting qubits or resonators is desirable for most of the quantum computing operations (e.g., large-scale quantum computation and simulation). It may be achieved by inserting an extra circuit element between the superconducting qubits or resonators, namely a coupling element which allows states of the superconducting qubits or resonators to interact with each other in a controlled manner. In other words, the coupling element arranged between the superconducting qubits or resonators allows one to implement a quantum gate.

Coupling elements are used in superconducting circuitry. Crosstalk between the coupling elements in a superconducting circuit can occur when an adjustment of a coupling element affects a coupling strength of another coupling element. This can cause unwanted interference between different parts of the circuit and potentially degrade its performance. For example, the adjustment, the operation, the idling of one coupling element or the nearest neighboring qubits can affect the circuit properties of the non-nearest neighbor circuitry. For example the characteristic frequencies of the computational elements (i.e. qubits, coupling elements, resonators) and the coupling strengths between those elements are subjected to variations. Examples of some ways in which crosstalk can occur between coupling elements:
- Electromagnetic crosstalk: Coupling elements in a superconducting circuitry are often located in close proximity to each other, and the magnetic field from one coupling element can couple to another coupling element, qubit, or resonator. This can cause changes in the magnetic flux and current distribution in the affected component, leading to changes in its coupling strength.
- Electrostatic crosstalk: Coupling elements may also couple through capacitive coupling, which occurs when the electric field from one coupling element affects the electric potential of other components. This can occur when the two coupling elements share a common ground or are located close to each other.
- Thermal crosstalk: Changes in the temperature of the circuit can affect the characteristics of the coupling elements, including their resonance frequency, quality factor, and coupling strength. This can result in crosstalk between different coupling elements in the circuit.

To mitigate crosstalk between coupling elements, several techniques can be used, including physical isolation of the coupling elements, adjusting the layout of the circuit to minimize the proximity of coupling elements, pulse engineering, using shielding to reduce electromagnetic interference, and optimizing the tuning range of the coupling elements to reduce the likelihood of interference. Additionally, simulation and modeling tools can be used to predict, analyze and compensate the potential crosstalk between different coupling elements in a superconducting circuitry and to optimize the circuit design and the pulse driving schemes accordingly. Crosstalk become harder to control when the number of components is scaled to larger chips.

In an example two superconducting qubits can be coupled by a tunable coupling element. The indirect interaction is mediated by the tunable coupling element itself. If the tunable coupling element is implemented as a single-island transmon, the coupling element characteristic frequencies are higher than qubit frequencies. If the tunable coupling element is implemented as a floating transmon, the coupling element characteristic frequencies can be both lower and higher than the qubit frequencies, giving the freedom to choose the circuit configuration.

### SUMMARY

This summary is provided to introduce a selection of concepts in a simplified form that are further described below in the detailed description. This summary is not intended to identify key features of the invention, nor is it intended to be used to limit the scope of the invention.

The objective of the invention is to provide a technical solution to frequency placement for qubit readout resonators.

The objective above is achieved by the features of the independent claims in the appended claims. Further embodiments and examples are apparent from the dependent claims, the detailed description and the accompanying drawings.

In some aspects, the subject matter of the present disclosure may be embodied in arrangements that include a plurality of qubits arranged in an at least two-dimensional topology; a plurality of readout resonators, each qubit of the plurality of qubits arranged to electromagnetically couple to a readout resonator of the plurality of readout resonators; a first readout transmission line arranged to electromagnetically couple to a first readout resonator group of at least two readout resonators of the plurality of readout resonators, wherein each readout resonator of the first readout resonator group is arranged to electromagnetically couple to a respective qubit of a first qubit group of at least two qubits of the plurality of qubits; and a second readout transmission line arranged to electromagnetically couple to a second readout resonator group of at least two readout resonators of the plurality of readout resonators, wherein each readout resonator of the second readout resonator group is arranged to electromagnetically couple to a respective qubit of a second qubit group of at least two qubits of the plurality of qubits, wherein the readout resonators of the first readout resonator group and the readout resonators of the first readout resonator group have resonance frequencies from a common readout frequency band, wherein at least part of the least two qubits of the second qubit group are nearest neighbors of at least part of the least two qubits of the first qubit group, and resonance frequencies of the readout resonators of the first readout resonator group and resonance frequencies of the readout resonators of the second readout resonator group are permuted at least for the nearest neighbors.

In some aspects, the subject matter of the present disclosure may be embodied in methods that comprise:
providing a plurality of qubits, a plurality of readout transmission lines, and a plurality of readout resonators,
wherein the plurality of qubits is arranged in an at least two-dimensional topology, wherein a first readout transmission line is arranged to couple to a first readout resonator group of at least two readout resonators of the plurality of readout resonators, each readout resonator of the first readout resonator group being coupled to a qubit of a first qubit group of at least two qubits of the plurality of qubits, and
wherein a second readout transmission line is arranged to couple to a second readout resonator group of at least two readout resonators of the plurality of readout resonators, each readout resonator of the second readout resonator group being coupled to a qubit of a second qubit group of at least two qubits of the plurality of qubits, and
wherein the readout resonators of the first readout resonator group and the readout resonators of the first readout resonator group have resonance frequencies from a common readout frequency band, and
wherein at least part of the least two qubits of the second qubit group are nearest neighbors of at least part of the least two qubits of the first qubit group, and resonance frequencies of the readout resonators of the first readout resonator group and resonance frequencies of the readout resonators of the second readout resonator group are permuted at least for the nearest neighbors.

The foregoing and other aspects can each optionally include one or more of the following features, alone or in combination:
∘ the readout resonators of the first readout resonator group have resonance frequencies from a first resonance frequency band and the readout resonators of the second readout resonator group have resonance frequencies from a second resonance frequency and the first resonance frequency band is overlapping with the second resonance frequency band;
∘ resonance frequencies of the readout resonators of the second readout resonator group are permuted at least for the second nearest neighbors;
∘ the first qubit group extends along the first readout transmission line, and wherein the second qubit group extends along the second readout transmission line;
∘ the first qubit group is at least partially directly adjacent to the second qubit group;
∘ at least one qubit of the first qubit group is arranged to electromagnetically couple to at least one qubit of the second qubit group, and wherein at least one qubit of the second qubit group is arranged to electromagnetically couple to at least one qubit of the first qubit group;
∘ the first group of qubits and the second group of qubits are unit cells and the resonance frequencies of readout resonators are permuted across the unit cells;
∘ the first qubit group along the first readout transmission line is at least partially directly adjacent to the second qubit group along the second readout transmission line;
∘ tuning each qubit of the first qubit group to a respective qubit frequency and tuning each qubit of the second qubit group to a respective qubit frequency, wherein qubit frequencies of the qubits of the first qubit group and qubit frequencies of the qubits of the second qubit group are from a common qubit frequency band;
∘ the readout resonators of the first readout resonator group have resonance frequencies from a first resonance frequency band and the readout resonators of the second readout resonator group have resonance frequencies from a second resonance frequency and the first resonance frequency band is overlapping with the second resonance frequency band;
∘ measuring a resonance frequency of a readout resonator of the first readout resonator group, and based on the measured resonance frequency, determining a state of a corresponding qubit of the first qubit group to which the readout resonator is coupled;
∘ at least one qubit of the first qubit group is arranged to electromagnetically couple to at least one qubit of the second qubit group, and wherein at least one qubit of the second qubit group is arranged to electromagnetically couple to at least one qubit of the first qubit group;
∘ couplings between a pair of qubits of the first qubit group and the second qubit group have a coupling rate, and wherein a frequency separation between a pair of coupled qubits may be at least ten times the coupling rate, or at least 50 times the coupling rate, or at least 100 times the coupling rate;
∘ a first unit cell comprises the first qubit group, wherein a second unit cell comprises the second qubit group, and wherein a third unit cell comprises a third qubit group of two or more qubits of the plurality of qubits, the first unit cell, the second unit cell, and the third unit cell being tiled in a first direction to form a unit cell pattern on the two-dimensional topology;
∘ tuning each qubit of the third qubit group to have a respective qubit frequency within a common qubit frequency band with qubit frequencies of the qubits of the first qubit group and qubit frequencies of the qubits of the second qubit group;
∘ resonance frequencies of readout resonators of the nearest neighbors are detuned.

At least some aspects provide mitigating crosstalk between coupling elements of a quantum circuit.

### BRIEF DESCRIPTION OF THE DRAWINGS

The invention is explained below with reference to the accompanying drawings in which:
FIGS. 1A-1B are schematics showing exemplary groups of qubits and readout resonators.
FIG. 2 is a schematic showing an exemplary pair of coupled qubits.
FIGS. 3-4 are schematics showing exemplary quantum processors.
FIG. 5A is a schematic showing an exemplary qubit array.
FIG. 5B is a schematic showing exemplary groups of readout resonators and readout transmission lines.
FIG. 5C is a schematic showing exemplary coupled qubits and readout resonators.

### DETAILED DESCRIPTION

The present disclosure relates to frequency placement for qubit readout resonators. In particular implementations, this disclosure relates to quantum processors in which qubit readout resonators of the quantum processors have resonance frequencies within particular defined bands.

Various embodiments of the invention are further described in more detail with reference to the accompanying drawings. However, the invention may be embodied in many other forms and should not be construed as limited to any certain structure or function discussed in the following description. In contrast, these embodiments are provided to make the description of the invention detailed and complete. According to the detailed description, it will be apparent to the ones skilled in the art that the scope of the invention encompasses any embodiment thereof, which is disclosed herein, irrespective of whether this embodiment is implemented independently or in concert with any other embodiment of the invention. For example, the circuits and arrangement disclosed herein may be implemented in practice by using any numbers of the embodiments provided herein. Furthermore, it should be understood that any embodiment of the invention may be implemented using one or more of the elements presented in the appended claims.

The word "exemplary" is used herein in the meaning of "used as an illustration". Unless otherwise stated, any embodiment described herein as "exemplary" should not be construed as preferable or having an advantage over other embodiments.

Any positioning terminology, such as "left", "right", "upper", "lower", etc., may be used herein for convenience to describe one element's or feature's relationship to one or more other elements or features in accordance with the figures. It should be apparent that the positioning terminology is intended to encompass different orientations of the circuit disclosed herein, in addition to the orientation (s) depicted in the figures. As an example, if one imaginatively rotates the circuit in the figures 90 degrees clockwise, elements or features described as "left" and "right" relative to other elements or features would then be oriented, respectively, "above" and "below" the other elements or features. Therefore, the positioning terminology used herein should not be construed as any limitation of the invention.

Although the numerative terminology, such as "first", "second", etc., may be used herein to describe various embodiments and the features thereof, it should be understood that the embodiments and the features thereof should not be limited by this numerative terminology. This numerative terminology is used herein only to distinguish one embodiment or feature from another embodiment or feature. Thus, a first embodiment discussed below could be called a second embodiment and vice versa, without departing from the teachings of the invention.

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

As used herein, "at least one of the following: " and "at least one of " and similar wording, where the list of two or more elements are joined by "and" or "or", mean at least any one of the elements, or at least any two or more of the elements, or at least all the elements.

Quantum processors often include readout resonators arranged to read out the states of qubits. Each readout resonator has a resonance frequency that varies by some small amount, the "dispersive shift," depending on the state (e.g., |0> or |1>) of the qubit to which the readout resonator is coupled. The readout resonator is also arranged to couple to a readout transmission line. A user, by probing the readout transmission line, can detect the resonance frequency of the readout resonator and thus infer the state of the qubit.

A qubit arranged to couple to a readout resonator can be tuned to a certain qubit frequency, with the difference between the qubit frequency and the resonance frequency of the readout resonator being the "qubit-resonator detuning." If the qubit-resonator detuning is too small, then the qubit may undergo undesired readout transitions or energy relaxation. However, if the qubit-resonator detuning is too large, then the dispersive shift may be too small to reliably detect. Therefore, the quantum processor may be designed and utilized such that all qubit-resonator detunings are within an optimal range.

It should be noted that the two-dimensional topology of qubits is illustrated herein by a two-dimensional array of the qubits. The terms "array" or "qubit array" are used herein interchangeably with term "the two-dimensional topology", though other patterns than arrays are possible such as serpentines of qubits, serpentines of qubit groups, serpentines of unit cells, splines of qubits, splines of qubit groups or splines of unit cells. An example of the two-dimensional topology of the qubits is a planar topology, where the qubits are arranged on the same plane, e.g. on the same planar surface, along a readout transmission line coupled to the qubits. Therefore, references to row(s), columns(s) or diagonal(s) of a qubit array should be understood to refer to a spline on the two-dimensional topology formed by qubits, or a qubit group, along the readout transmission line. In an example, the qubit group may be formed by qubits, whose readout resonators are coupled to a common readout transmission line. Two qubit groups may be arranged on the two-dimensional topology along parallel splines, for example along two parallel diagonals, parallel rows, or parallel columns.

In some embodiments, multiple readout resonators are arranged to couple to a single readout transmission line. To allow the qubits coupled to the respective readout resonators to be read individually, each of the readout resonators coupled to the readout transmission line may have resonance frequencies that are different from one another.

In some embodiments, a readout transmission line is arranged to couple to an amplifier, which may properly amplify signals with frequencies in a particular amplifier frequency band. To maintain a high quality of amplification, the readout resonators arranged to couple to the readout transmission line may have resonance frequencies that are within the amplifier frequency band, while still being sufficiently far apart from one another to allow individual readout of the respective coupled qubits.

In some embodiments, readout transmission lines have a common readout frequency band and the amplifiers that are coupled to different readout transmission lines can have amplifier frequency bands that overlap with the common readout band. This facilitates manufacturing and reduces complexity of quantum processors.

In some embodiments, one or more qubits may be arranged to couple to one another, and coupled qubits may be tuned to have qubit frequencies that are sufficiently different to allow operation of qubits in isolation. For example, the qubits may be in an array, and each qubit, or at least one qubit, may be arranged to directly couple to one or more qubits that are its nearest-neighbor qubits. The strength of an interaction between two coupled qubits depends in part on the relative qubit frequencies to which the qubits are tuned, becoming stronger when the two qubit frequencies are closer together. To operate on a qubit individually, without undesired qubit-qubit interactions, the qubit frequency of the qubit may be tuned to be separated from the qubit frequencies of nearest-neighbor qubits.

This disclosure describes quantum processor design elements that allow some or all of the above design features to be included in a quantum processor.

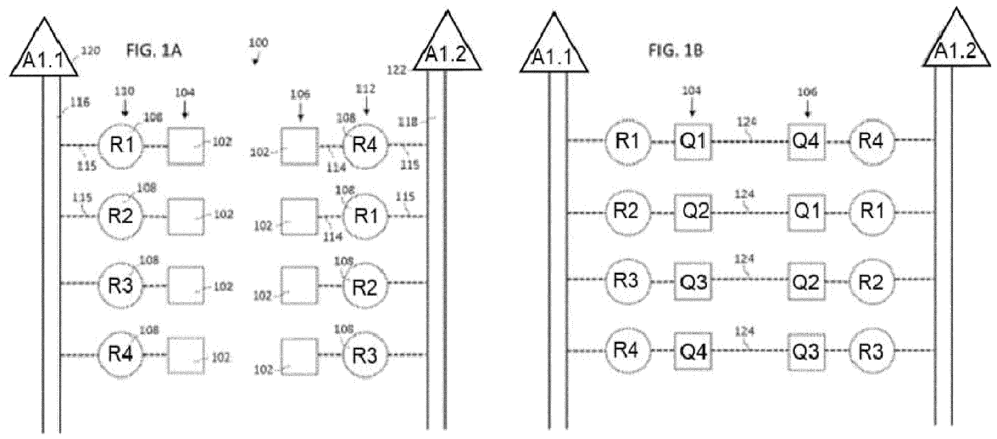

In the example of FIG. 1A, a quantum processor 100 includes multiple qubits 102. The qubits 102 include a first qubit group 104 and a second qubit group 106. The qubits 102 may be arranged in, for example, a two-dimensional topology.

Each qubit 102 can be tuned to a particular qubit frequency by the application of appropriate signals (e.g. Direct Current and microwave signals) to control elements coupled to each qubit (not shown). Qubits 102 can be operable in two or more modes, for example, an idling mode and a readout mode, and qubits can be tuned to different frequencies depending on the current operation mode.

The quantum processor 100 also includes multiple readout resonators 108. The readout resonators 108 include a first readout resonator group 110 and a second readout resonator group 112. Each readout resonator 108 has a respective resonance frequency and is arranged to electromagnetically couple to a corresponding qubit 102, as indicated by dashed lines (e.g., couplings 114).

Each readout resonator 108 in the first readout resonator group 110 is arranged to electromagnetically couple to a first readout transmission line 116, and each readout resonator in the second readout resonator group 112 is arranged to electromagnetically couple to a second readout transmission line 118, as indicated by dashed lines (e.g., couplings 115).

The readout resonators 108 and the readout transmission lines 116, 118 may be implemented as readout transmission line resonators, for example, quarter-wave or half-wave superconductor co-planer waveguide resonators or strip-line resonators. Other resonators designs are also possible.

The readout resonators 108 may be positioned along the respective qubit readout transmission lines 116, 118 such that, during operation of the quantum processor 100, a standing wave profile established in a readout resonator 108 is matched to a standing wave profile established in the respective readout transmission line 116, 118. That is, the standing wave profile of a readout resonator 108 is both impedance and phase matched to the standing wave profile of the respective readout transmission line 116, 118. Because the standing wave profile along the readout transmission lines 116, 118 varies as a function of length, the coupling location along each readout resonator 108 will also vary.

The resonance frequency of each readout resonator 108 can be determined in part by, for example, a length of the readout resonator 108. The resonance frequency of each readout resonator 108 is also determined in part by the state of the qubit 102 to which the readout resonator 108 is arranged to electromagnetically couple, varying by the dispersive shift. This dispersive shift allows the readout of the qubit states by probing of the readout transmission lines 116, 118. However, the dispersive shift is typically small compared to the resonance frequency itself, such that it is possible to refer to designed "resonance frequencies" that approximately match the actual resonance frequency of a given readout resonator 108, regardless of any small dispersive shift induced by a coupled qubit. For example, a resonance frequency may be several GHz, and a dispersive shift may be several MHz.

As indicated in FIG. 1A, the readout resonators 108 in the first readout resonator group 110 and the readout resonators 108 in the second readout resonator group 112 have resonance frequencies from a common frequency band. In an example, the readout resonators 108 in the first readout resonator group 110 and the readout resonators 108 in the second readout resonator group 112 both have resonance frequencies R1, R2, R3 and R4. At least part of the qubits of the second qubit group 106 are nearest neighbors of at least part of the least the qubits of the first qubit group 104, whereby resonance frequencies of the readout resonators of the first readout resonator group 100 and resonance frequencies of the readout resonators of the second readout resonator group 112 are permuted at least for the nearest neighbors.

When a readout transmission line 116, 118 is probed at a frequency approximately matching the resonance frequency of a readout resonator 108 coupled to the readout transmission line 116, 118, a resulting output signal returns the current resonance frequency (e.g., the designed resonance frequency modulated by the dispersive shift), allowing the inference of the state of the qubit 102 coupled to the readout resonator 108. However, if multiple readout resonators 108 along a given readout transmission line 116, 118 have similar resonance frequencies, it may be unclear which qubit 102 is in which state. Therefore, the readout resonators 108 within each readout resonator group 110, 112 may be designed to have resonance frequencies that are different from one another. In cases where the readout resonators 108 can be characterized by a linewidth of their resonance frequencies, the resonance frequencies along each readout transmission line 116, 118 may be separated by at least the linewidth. The resonance frequencies of readout resonators 108 along each readout transmission line 116, 118 may be separated by, for example, at least 25 MHz, at least 40 MHz, or at least 50 MHz.

In some embodiments, measurement of a readout resonator may collapse the quantum state of a corresponding qubit coupled to the readout resonator. When readout resonators within each readout resonator group have different resonance frequencies, states of qubits coupled to a portion of the readout resonators may be read out without collapsing the quantum states of qubits coupled to other readout resonators in the readout resonator group.

Each readout transmission line 116, 118 is arranged to couple to a respective amplifier 120, 122. Each amplifier 120, 122 may comprise, for example, an amplification chain, including cold and warm amplifiers. A cold amplifier is operated at cryogenic temperatures that allow a superconductor material to exhibit superconducting properties typically used to amplify small electronic signals while maintaining low levels of noise. A warm amplifier is operated above the cryogenic temperatures.

. In some embodiments, each amplifier 120, 122 may only perform its function properly (e.g., with higher magnitudes of amplification and with constant amplification levels across frequencies) within a respective amplifier frequency band A1.1, A1.2. Therefore, resonance frequencies of the readout resonators 110,0 112 coupled to a respective readout transmission line 116, 118 may be within the amplifier frequency band of the respective amplifier. Therefore, the resonance frequencies R1, R2, R3 and R4 may be from a common readout frequency band within the amplifier frequency bands A1.2, A1.2. In an example, the amplifier frequency bands A1.2, A1.2 may overlap with the common readout frequency band or be the same. It should be noted that the frequency bands of the amplifiers are the same at least, when each of the amplifiers are operated to amplify a probe signal at the same frequency for probing a respective readout transmission line. The frequency of the probe signal may approximately match the resonance frequency of the readout resonator 108 coupled to the respective readout transmission line 116, 118. The resonance frequencies of the readout resonators coupled to the respective readout transmission lines 116, 118 may be the same or at least from a common frequency band, e.g. a readout frequency band. In an example, the resonance frequencies of the readout resonators coupled to one 116 of the transmission lines are R1, R2, R3 and R4 and the resonance frequencies 118 of the readout resonators coupled to another one 118 of the transmission lines are R1, R2, R3 and R4, whereby the resonance frequencies of the readout resonators are permuted between the transmission lines at least for readout resonators that are coupled to qubits that are nearest neighbors. Accordingly, the resonance frequencies of the readout resonators coupled to each of the transmission lines are the same, but their assignment to the readout resonators is determined such that the readout resonators of the nearest neighbor qubits are different.

It should be noted that an amplifier frequency band may have a bandwidth of, for example, 200 MHz, 300 MHz, or 400 MHz. In embodiments in which corresponding resonance frequency bands are within respective amplifier frequency bands, resonance frequency bands may be as small as tens of megahertz.

FIG. 1B shows a quantum processor having the configuration of the quantum processor 100 of FIG. 1A. The components of FIG. 1B operate as described for the components of FIG. 1A, except where noted otherwise.

In the example of FIG. 1B, one or more qubits within the first qubit group 104 are arranged to electromagnetically couple to one or more qubits within the second qubit group 106, as indicated by dashed lines (e.g., couplings 124). In an example, the qubits in the first qubit group 104 and the qubits in the second qubit group 106 have qubit frequencies from a common qubit frequency. In an example, the qubits in the first qubit group and the qubits in the second qubit group both have qubit frequencies Q1, Q2, Q3 and Q4. Accordingly, the qubit frequencies of the qubit of the first qubit group and the second qubit group are the same, but their assignment to the qubits is determined such that the qubit frequencies of the nearest neighbor qubits are different.

As explained herein, the difference between a readout resonator's resonance frequency and the corresponding qubit's qubit frequency is referred to as the qubit-resonator detuning. If the qubit-resonator detuning is too large, then the dispersive shift in the resonance frequency induced by the qubit may be too small to reliably measure, or may be too small to reliably indicate the qubit state. However, if the qubit-resonator detuning is too small, then the qubit may exhibit increased energy relaxation, e.g., undergo undesired transitions. Therefore, in some embodiments, there is a preferred range of values for the qubit-resonator detuning. it should be noted that each qubit and its respective readout resonator maybe detuned.

In some embodiments, the qubit-resonator detuning may be at least 250 MHz, at least 500 MHz, or at least 1000 MHz. The qubit-resonator detuning may have a minimum value that depends on, for example, a qubit-resonator coupling strength or a nonlinearity of the qubit.

Although FIGS. 1A-1B show two groups of readout resonators with permuted resonance frequencies for readout resonators of two qubit groups, in some embodiments there are more than two groups of qubits and/or there is more than one nearest neighbor for each qubit. Although FIGS. 1A-1B show eight qubits, eight readout resonators, and two readout transmission lines, in some embodiments there are more or fewer of any of those components.

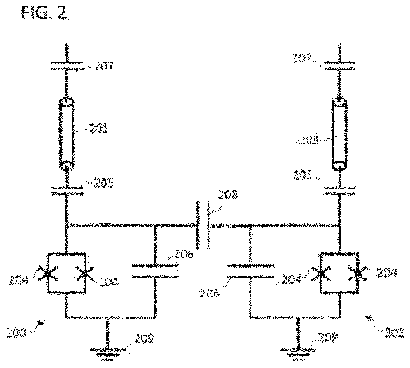

FIG. 2 shows two coupled transmon qubits 200, 202, each including two Josephson junctions 204 and a capacitance 206. The two qubits 200, 202 are arranged to electromagnetically couple via a capacitance 208. In some embodiments, qubits are arranged to electromagnetically couple via a tunable coupler. In some embodiments, each qubit is electrically connected to a common electrical ground 209.

Qubit 200 is arranged to electromagnetically couple to a first readout resonator 201, and qubit 202 is arranged to electromagnetically couple to a second readout resonator 203. The couplings may be, as shown, capacitive (e.g., capacitances 205). Each readout resonator 201, 203 is respectively coupled (e.g., via a capacitance 207) to a respective readout transmission line (not shown).

Various qubit designs are within the scope of this disclosure. The qubits may be, for example, transmon qubits or fluxonium qubits for example. The qubits may be phase qubits, charge qubits, flux qubits, or hybridizations thereof. The qubits may include SQUIDs. Each qubit may include multiple superconductor islands.

Because the qubits 200, 202 in FIG. 2 are arranged to electromagnetically couple via the capacitance 208, the coupling may be referred to as a "direct" coupling. That is, during operation of the quantum processor, the coupling has a strength that depends on the relative qubit frequencies of the qubits 200, 202. In other embodiments, "indirect" coupling (i.e., coupling mediated through an additional circuit element) between qubits may be additionally or alternatively provided for; again, in some examples such indirect coupling may be dependent upon the relative frequencies of the qubits.

Thus, the strength of the coupling may depend on the relative qubit frequencies to which the qubits 200, 202 are tuned. When the qubit frequencies are closer together, the coupling strength is stronger, and, conversely, when the qubit frequencies are detuned from one another, the coupling strength is weaker. Therefore, when the qubits 200, 202 are not being used to perform entangling operations, the qubits 200, 202 may be tuned to have qubit frequencies that are sufficiently different, such that the qubits 200, 202 do not interact with one another in undesired ways. If qubit 200 has a qubit frequency, e.g. Q1, and qubit 202 has a different qubit frequency, e.g. Q2, undesired qubit-qubit interactions can be reduced or eliminated by a frequency separation between the different qubit frequencies.

In some embodiments, a coupling between qubits, e.g. a pair of qubits, may be characterized by a coupling rate, and the qubit frequency difference, or the frequency separation between qubit frequencies of a pair of coupled qubits may be at least ten times the coupling rate, or at least 50 times the coupling rate, or at least 100 times the coupling rate.

In some embodiments, a coupling rate between qubits, e.g. a pair of qubits, may be 10 MHz -100 MHz, and the frequency separation between qubit frequencies of a pair of coupled qubits may be 200MHz, when tunable couplers are used.

Couplings between qubits in the context of readout resonators may create further opportunities for qubit state losses and undesired transitions. For example, in reference to FIG. 2 , if readout resonator 203 is probed in order to measure the state of qubit 202, additional excitation states may be generated in the combined qubit-resonator (202-203) system. Some of these additional excitation states may be in resonance with qubit 200, such that qubits 200 and 202 may undergo a state swap. Maintaining a sufficient separation between the qubit frequencies of qubits 200 and 202 while also maintaining a sufficient qubit-resonator detuning, as described above, may reduce the likelihood of this phenomenon and others.

This disclosure has identified several features that may be included in a quantum processor. First, the qubit-resonator detunings may fall within an optimal range, being neither too small (in order to avoid energy relaxation and undesired transitions) nor too large (in order to allow qubit state readout). Second, readout resonators along a single readout transmission line may have resonance frequencies that are different from one another but that also fall within the amplifier frequency band of an amplifier coupled to the readout transmission line. Third, coupled qubits may be tuned to have sufficiently different qubit frequencies, such that undesired qubit-qubit interactions are avoided. Fourth, resonance frequencies of readout resonators are permuted at least for the qubits that are nearest neighbors.

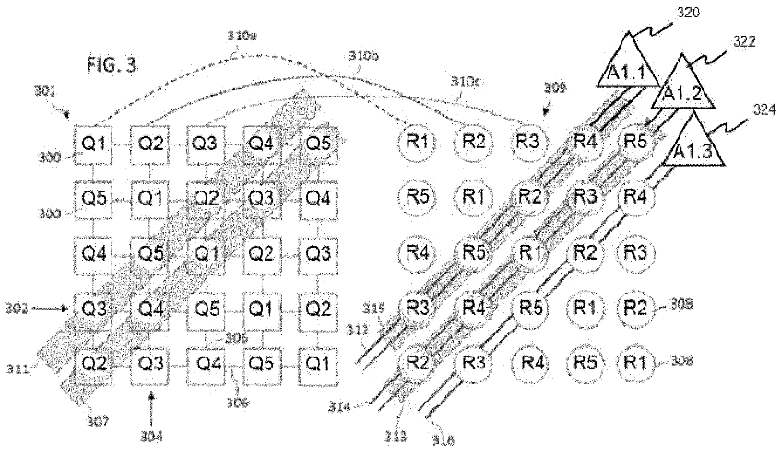

The example of FIG. 3 shows a quantum processor design capable of including at least part of these several features. Qubits (e.g., qubits 300) are arranged in a two-dimensional qubit array 301, such that nearest-neighbor qubits within each row (e.g., row 302) and within each column (e.g., column 304) are arranged to electromagnetically couple with one another, as indicated by dashed lines (e.g., couplings 306). At least some qubits of a first qubit group 307 extending along a first diagonal of the qubit array 301 have a nearest neighbor in a second qubit group 311 extending along a second diagonal of the qubit array 301 have a qubit frequency within a second qubit frequency band. The qubit frequencies are tuned with qubit frequencies Q1 , Q2 , Q3 , Q4 , and Q5 within each row and column, and each qubit in the first qubit group 307 is arranged to electromagnetically couple to at least one qubit in the second qubit group 311, and each qubit in the second qubit group 311 is arranged to electromagnetically couple to at least one qubit in the first qubit group 307. Each qubit group 307, 311 includes qubits extending along a respective diagonal of the qubit array 301. Qubits in the first qubit group 307 are directly adjacent to qubits in the second qubit group 311. Thus, each qubit of the first qubit group has a nearest neighbor qubit in the second qubit group. The qubit frequencies Q1 , Q2 , Q3 , Q4 , and Q5 are permuted between adjacent rows and columns, whereby nearest neighbors of the qubits of both of the qubit groups have different qubit frequencies and are thus detuned.

The quantum processor also includes multiple readout resonators (e.g., readout resonators 308). In FIG. 3 , these readout resonators are shown arranged in a two-dimensional resonator array 309 matching the two-dimensional qubit array 301, meaning that each readout resonator is arranged to electromagnetically couple to the corresponding qubit having a position in the qubit array 301 that matches the readout resonator's position in the resonator array 309. Several of these couplings are indicated by the dashed lines 310 a, 310 b, 310 c. Note, though, that the respective positions of the qubit array 301 and the resonator array 309 are merely for schematic illustration. In some embodiments, the arrays 301 and 309 are superimposed, with, for example, each readout resonator adjacent to the qubit to which the readout resonator is coupled. In some embodiments, the qubits define enclosed areas between qubits, and the readout resonators are each in a respective enclosed area. In some embodiments, even when the qubits 300 are arranged in an array, the readout resonators 308 themselves are not arranged in a corresponding array.

The readout resonators include a first group of readout resonators 313 and a second group of readout resonators 315 which have resonance frequencies from a common readout frequency band. In this example, both the first group of readout resonators 313 and the second group of readout resonators 315 have the same readout resonator frequencies R1, R2, R3, R4, R5 that are permuted at least for readout resonators of nearest neighbor qubits. Each qubit having a qubit frequency in the qubit frequency band Q1 is arranged to electromagnetically couple to a respective readout resonator having a resonance frequency in the resonance frequency band R1, and each qubit having a qubit frequency in the qubit frequency band Q2 is arranged to electromagnetically couple to a respective readout resonator having a resonance frequency in the resonance frequency band R2. The qubit frequency band Q1 is at least partially overlapping with the qubit frequency band Q2. Each readout resonator in the first readout resonator group 313 is arranged to electromagnetically couple to a respective qubit in the first qubit group 307 along a first diagonal of the qubit array 301, and each readout resonator in the second readout resonator group 315 is arranged to electromagnetically couple to a respective qubit in the second qubit group 311 along a second diagonal of the qubit array 301. As will be illustrated below, this pattern of couplings helps include the noted design features.

Readout transmission lines 312, 314, 316 are arranged to electromagnetically couple to respective groups of readout resonators, as shown. For example, readout transmission line 314 couples to the first group of readout resonators 313, and readout transmission line 312 couples to the second group of readout resonators 315. Note that other readout transmission lines, not shown, may be included to couple to the remaining readout resonators.

Each readout transmission line 312, 314, 316 is arranged to read out, via a respective group of readout resonators, qubits in a respective qubit group lying along a respective diagonal of the qubit array 301. For example, readout transmission line 312 can be used to read out the states of qubits in the second qubit group 311. Adjacent diagonals of the qubit array 301 (e.g., adjacent qubit groups, each qubit group extending along a diagonal of the qubit array 301) may correspond to different readout resonator groups having different resonance frequency bands. In some embodiments, the readout resonators are physically arranged in the readout resonator array 309 (which may be superimposed over the qubit array 301), the readout resonator array 301 is oriented such that the readout resonators are in relative positions to each other corresponding to the relative positions of the readout resonators' respective coupled qubits in the qubit array 301, and the readout transmission lines 312, 314, 316 physically extend along diagonals of the readout resonator array 309 and/or diagonals of the qubit array 301.

Each readout transmission line 312, 314, 316 is also arranged to be coupled to a respective amplifier 320, 322, 324. Each amplifier 320, 322, 324 has a corresponding amplifier frequency band A1.1, A1.2 and A1.3. The amplifier frequency bands A1.1, A1.2 and A1.3 may overlap with a readout frequency band that is common to the readout resonators of the transmission lines 312, 314, 316. In an example, each of the amplifiers may have an amplifier frequency band examples of which comprise a frequency band from 2 GHz to 12 GHz and a frequency band from 4 GHz to 8 GHz. A readout frequency band may be from 5 GHz to 6 GHz, whereby the amplifiers can be operated to amplify signals on the common readout frequency band, that includes the resonance frequencies R1, R2, R3, R4, R5. In an example, the amplifier frequency bands A1.1, A1.2 and A1.3 may even be the same, thus A1.1~=A1.2~=A1.3. As shown in FIG. 3 , amplifiers 320, 322, 324 having amplifier frequency bands A1.1, A1.2 and A1.3 respectively are arranged to electromagnetically couple to readout resonators having resonance frequencies, R1, R2, R3, R4, R5. In this way each amplifier 320, 322, 324 can be operated to amplify signals on a common readout frequency band, that includes the resonance frequencies R1, R2, R3, R4, R5. In this way a single amplifier capable of operating over the common frequency band, thus including R1, R2, R3, R4, R5, may be used for all readout transmission lines 312, 314, 316.

As indicated above in reference to FIGS. 1A-1B, Although FIG. 3 show two groups of readout resonators with permuted resonance frequencies for readout resonators of two qubit groups, in some embodiments there are more than two groups of qubits and/or there are more than one nearest neighbor for each qubit. Although FIGS. 1A-1B show eight qubits, eight readout resonators, and two readout transmission lines, in some embodiments there are more or fewer of any of those components. Although FIG. 3 shows qubits in a 5×5 array, in some embodiments the qubits are in an array having different dimensions or are not arranged in an array.

In some embodiments, the quantum processor (e.g., the quantum processor of FIG. 3 ) is based on unit cells, each unit cell including a group of qubits and corresponding readout and control elements used to control and read out that group of qubits. Each unit cell may be configured such that components included in the unit cell do not overlap with components of other unit cells. Therefore, in some embodiments, a unit cell-based quantum processor may allow tiling of unit cells in one or more dimensions to expand the number of qubits in the quantum processor. In an example, the unit cells may be tiled in a particular direction, such that the first unit cell is adjacent to the second unit cell, and the second unit cell is adjacent to both the first unit cell and the third unit cell. It should be noted that additional unit cells may also be included (e.g., adjacent to the third unit cell), and the additional unit cells may continue the alternating qubit frequency band arrangement. The unit cells may be tiled to form a pattern of unit cells on a two-dimensional topology, e.g. a unit cell array.

In some embodiments, the resonance frequencies of readout resonators are permuted across the unit cells.

In some embodiments, adjacent unit cells have one or more qubits that each other's nearest neighbors. Therefore, resonance frequencies of readout resonators may be performed across two or more unit cells.

In some embodiments, resonance frequencies of readout resonators of nearest neighbor qubits, or qubit frequencies of nearest neighbor qubits, or both, may be permuted between adjacent unit cells.

In some embodiments, components included in each unit cell do not overlap with components included in other unit cells. For example, components may be arranged on a side of a chip, a first area of the chip may include components of only a first unit cell, and a second area of the chip may include components of only a second unit cell. This may allow unit cells to be tiled without components from different unit cells interfering with one another, e.g., without readout transmission lines intersecting one another.

Each unit cell may include, for example, a group of qubits along a diagonal of a qubit array, along with associated readout elements. For example, a unit cell might include the first qubit group 307, the first readout resonator group 313, and the readout transmission line 314. In some embodiments, qubits in each unit cell are arranged to couple to qubits in adjacent unit cells. In some embodiments, qubits within each unit cell are arranged to be read using a single readout transmission line. In some embodiments, the frequency relations and frequency characteristics described herein for "groups" of components may apply to unit cells of components.

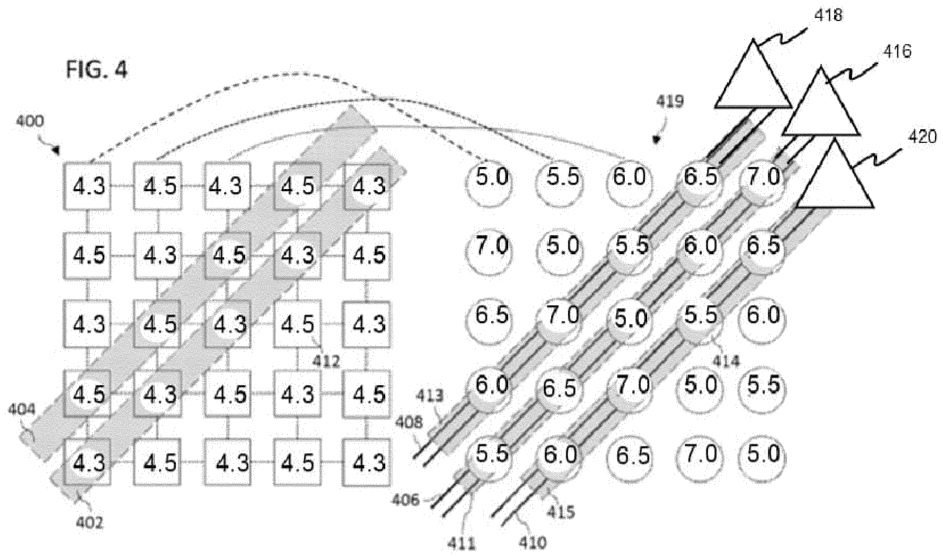

FIG. 4 shows a quantum processor according to the design of FIG. 3 , except that FIG. 4 shows example numbers, in GHz, for the qubit frequencies, resonance frequencies, and amplifier frequency bands. The example numbers are displayed inside each component, or, for the amplifier frequency bands, adjacent to each amplifier.

As shown in FIG. 4 , the qubits have qubit frequencies 4.3 GHz and 4.5 GHz. For example, a first group of qubits 402 extending along a first diagonal of a qubit array 400 has qubit frequencies 4.3GHz, and a second group of qubits 404 extending along a second diagonal of the qubit array 400 has qubit frequencies 4.5 GHz. In this case, then, the first group of qubits and the second group of qubits are on a common frequency band between 4.3 to 4.5 GHz. The qubit frequencies are permuted between adjacent rows and columns.

At least a part of the qubits of the first qubit group are coupled to one or more of the qubits of the second qubit group, thereby forming adjacent qubits that are nearest neighbors. The qubit frequencies of the first qubit group are permuted at least for the nearest neighbors, whereby frequency separation between the nearest neighbors may be achieved. This reduces or eliminates interactions between the qubits, even when the qubits are, for example, directly capacitively coupled. It should be noted that, the qubits may be tuned to have more similar qubit frequencies when, during operation of the quantum processor, it is desired that qubits interact with one another more strongly. It should be appreciated that the qubits frequencies are examples and may be varied, when implemented.

In some embodiments, the qubit frequency separation between coupled qubits may be tuned to be, for example, at least 100 MHz, at least 0.5 GHz, at least 0.75 GHz, at least 1.0 GHz, or at least 1.25 GHz.

The readout resonators include multiple readout resonators having resonance frequencies from 5 GHz to 7 GHz at 5.0 GHz, 5.5 GHz, 6.0 GHz, 6.5 GHz and 7.0 GHz. For example, readout resonators coupled to readout transmission line 406 are in a first readout resonator group 411 and have resonance frequencies 5.5, 6.5, 5.0, 6.0 and 7.0 GHz; readout resonators coupled to readout transmission line 408 are in a second readout resonator group 413 and have resonance frequencies 6.0, 7.0, 5.5 and 6.5 GHz; and readout resonators coupled to readout transmission line 410 are in a third readout resonator group 415 and have resonance frequencies 6.0, 7.0, 5.5 and 6.5 GHz. Accordingly, the resonance frequencies of the readout resonators are permuted between the readout resonator groups at least for readout resonator of nearest neighbor qubits. The remaining readout resonators, which are coupled to readout transmission lines that are not shown in FIG. 4 , may be permuted in a similar manner.

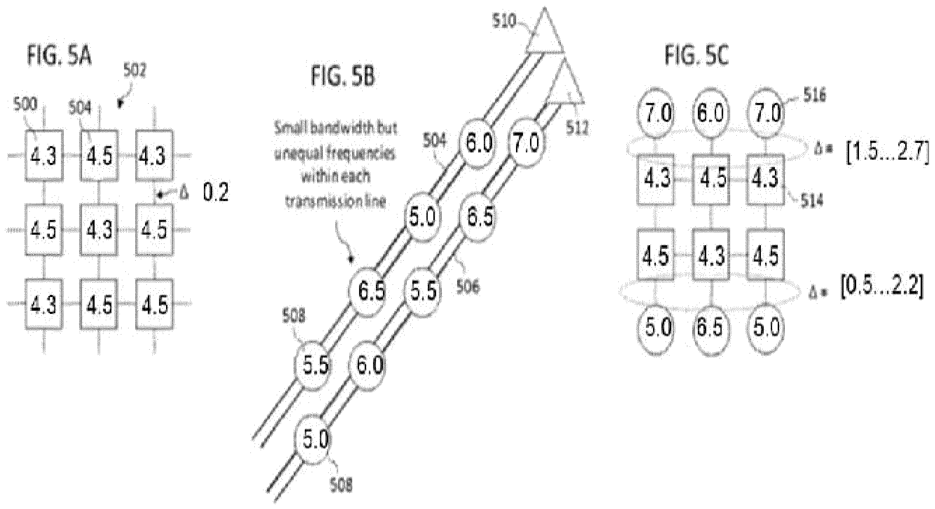

Within each readout resonator group 411, 413, 415, resonance frequencies are separated by an intra-band resonance frequency separation. In the example of FIG. 5 , readout resonators coupled to readout transmission line 408 have resonance frequencies 6.0, 7.0, 5.5 and 6.5 GHz, whereby the intra-band resonance frequency separation is 0.5 GHz. Therefore, the respective qubits coupled to each of these readout resonators can be individually read out via application of a pulse of appropriate frequency to the readout transmission line 408. For example, to read out qubit 412, which is coupled to readout resonator 414 having resonance frequency 5.5 GHz, a signal having frequency 5.5 GHz may be applied to readout transmission line 410.

In some embodiments, the intra-band resonance frequency separation along a single readout transmission line is different for different pairs of closest-resonator-frequency readout resonators. For example, four readout resonators coupled to a single readout transmission line may have respective resonance frequencies of 6.5, 5.0, 6.0 and 7.0 GHz.

As explained herein, the qubit-resonator detuning may be set to a preferred range of values. In the example of FIG. 4, readout resonators having resonance frequencies between 5.0, 5.5, 6.0, 6.5 and 7.0 GHz are arranged to electromagnetically couple to qubits having qubit frequency at 4.3 GHz or at 4.5 GHz. Therefore, the qubit-resonator detuning may be between 0.7 GHz and 2.7 GHz, e.g. 2.7 GHz qubit-resonator detuning between readout resonator frequency 7.0 GHz and qubit frequency 4.3 GHz. If, for example, the qubits have anharmonicity 200 MHz, then a desired minimum value of the qubit-resonator detuning may be 1.2 GHz, and a condition for minimum qubit-resonator detuning may therefore be satisfied. Undesired transitions and interactions, such as state-swapping, may therefore be reduced.

As explained herein, resonance frequency bands may be within corresponding amplifier frequency bands. In the example of FIG. 4, the readout transmission lines 406, 408, 410 are arranged to electromagnetically couple to respective amplifiers 416, 418, 420. The amplifiers 416, 418, 420 may have respective amplifier frequency bands matching the resonance frequencies of the readout resonators from 5.0 GHz to 7.0 GHz. Examples of amplifier frequency bands to the respective amplifiers 416, 418, 420 are 5 GHz - 7 GHz, 4 GHz - 8 GHz and 2 GHz - 12 GHz. The readout resonators coupled to the readout transmission lines 406, 408, 410 of these respective amplifiers 416, 418, 420 have resonance frequencies, e.g. 5.0, 5.5, 6.0, 6.5 and 7.0 GHz, within these amplifier frequency bands. Because of this, amplifiers of each readout transmission line may have an amplifier frequency band that is overlapping with a readout frequency band of the readout resonators of the transmission lines, whereby the same type of amplifier can be used for each of the transmission lines.

Note that the frequency values shown in FIG. 4 are merely examples. A wide variety of frequency values, desired frequency relationships, patterns of qubit groups and resonator groups, ranges of frequency bands, and physical layouts of the processor components are within the scope of this disclosure.

In some embodiments, the use of different qubit frequency bands and different resonance frequency bands for two groups of qubits and two groups of readout resonators may reduce crosstalk compared to examples in which qubits from two qubit groups are read out via the same readout transmission line. For example, a readout procedure might include probing only a readout transmission line coupled to readout resonators coupled to qubits in the second qubit group, reducing the chance of accidentally reading out the state of a qubit in the first qubit group.

FIGS. 5A-5C show selected portions of the quantum processor of FIG. 4 in order to illustrate how the design of the quantum processor of FIG. 4 includes the design features outlined above. Note that, as shown in FIG. 4 , the configuration of components in FIGS. 5A-5C may be simultaneously included in a single quantum processor; the components are schematically broken out separately into FIGS. 5A-5C for clarity.

As shown in FIG. 5A, nearest-neighbor qubits along rows and columns of the two-dimensional qubit array 502 are coupled. For example, a first qubit 500 is coupled to a second qubit 504 that is a nearest neighbor to the first qubit 500. Qubit frequency bands (qubit frequency values being shown inside each qubit) alternate along the rows and columns, such that the qubit frequency difference between coupled, nearest-neighbor qubits (e.g., qubits 500 and 502) is at least some minimum value (in the example of FIG. 5A, 0.2 GHz). Therefore, in this configuration of the quantum processor, the coupling strength between nearest-neighbor qubits will be smaller than if coupled qubits had qubit frequencies closer in value, and undesired qubit-qubit interactions may be reduced or eliminated.

As shown in FIG. 5B, along each readout transmission line 504, 506, the resonance frequencies (shown inside each readout resonator, e.g., readout resonators 508) of the readout resonators differ from one another. In the example of FIG. 5B, the resonance frequencies along each transmission line differ by an intra-band resonance frequency separation of 0.5 GHz, allowing multiplexed, individual readout of the qubits (not shown) coupled to the readout resonators.

In addition, the resonance frequencies along each readout transmission line 504, 506 are from 5.0 GHz to 7 GHz, thus within the amplifier frequency bands, e.g. from 5 GHz - 7GHz, 4 GHz - 8 GHz and 2 GHz - 12GHz, of respective amplifiers 510, 512 arranged to couple to the readout transmission lines 504, 506. The amplifiers 510, 512 will therefore properly amplify resonance frequency signals going to or from the readout resonators, while decreasing any loss of signal fidelity.

As shown in FIG. 5C, each qubit is arranged to electromagnetically couple to a corresponding readout resonator (e.g., qubit 514 can couple to readout resonator 516). The qubit-resonator detunings of the quantum processor of FIG. 5C are from 0.5 GHz to more than 1.5 GHz and up to 2.7 GHz, as shown, which allows state fidelities to be maintained and the occurrence of undesired transitions, such as state-swapping between qubits, to be reduced. These values of qubit-resonator detuning are merely an example; a range of qubit-resonator detuning values is within the scope of this disclosure.

Electromagnetic couplings between components may be, for example, capacitive, inductive, or both capacitive and inductive. In some embodiments, couplings between components are couplings through a space between two chips on which two components are respectively positioned. For example, in some implementations, a qubit positioned on a first chip may be electromagnetically coupled to a readout resonator positioned on a second separate chip that is bump bonded to and facing the first chip. In some embodiments, couplings are in-plane, with a direction of a coupling electric field and/or magnetic field being substantially in a plane of a side of a chip on which both of two components are positioned. For example, in some implementations, a qubit on a first surface of a silicon substrate may be electromagnetically coupled to a readout resonator on the first surface of the silicon substrate.

Quantum circuit components (also referred to as quantum computing circuit components) disclosed herein include circuit components for performing quantum processing operations. That is, the quantum circuit components are configured to make use of quantum-mechanical phenomena, such as superposition and entanglement, to perform operations on data in a non-deterministic manner. Certain quantum circuit components, such as qubits, may be configured to represent and operate on information in more than one state simultaneously. Examples of superconducting quantum circuit components include circuit elements such as quantum LC oscillators, qubits (e.g., flux qubits, phase qubits, or charge qubits), readout resonators, readout transmission lines, amplifiers, and superconducting quantum interference devices (SQUIDs) (e.g., RF-SQUID or DC SQUID), among others.

In contrast, classical circuit elements generally process data in a deterministic manner. Classical circuit elements may be configured to collectively carry out instructions of a computer program by performing basic arithmetical, logical, and/or input/output operations on data, in which the data is represented in analog or digital form. In some implementations, classical circuit elements may be used to transmit data to and/or receive data from the quantum circuit components through electrical or electromagnetic connections. Examples of classical circuit elements include circuit elements based on CMOS circuitry, rapid single flux quantum (RSFQ) devices, reciprocal quantum logic (RQL) devices and ERSFQ devices, which are an energy-efficient version of RSFQ that does not use bias resistors.

Any or all of the components mentioned in this disclosure, including the qubits, the readout resonators, the readout transmission lines, and the amplifiers, may be made of a superconductor material, such as aluminum, niobium, or titanium nitride, among other superconductor materials. The components may include both superconductor and non-superconductor material.

Fabrication of the circuit elements disclosed herein may entail the deposition of one or more materials, such as superconductors, dielectrics and/or metals. Depending on the selected material, these materials can be deposited using deposition processes such as chemical vapor deposition, physical vapor deposition (e.g., evaporation or sputtering), or epitaxial techniques, among other deposition processes. Processes for fabricating circuit elements described herein may entail the removal of one or more materials from a device during fabrication. Depending on the material to be removed, the removal process may include, e.g., wet etching techniques, dry etching techniques, or lift-off processes. The materials forming the circuit elements described herein can be patterned using known lithographic techniques (e.g., photolithography or e-beam lithography).

During operation of a quantum computational system that uses circuit elements formed, in part, from superconductors, such as the circuit elements described herein, the circuit elements are cooled down within a cryostat to temperatures that allow a superconductor material to exhibit superconducting properties. A superconductor (also referred to as superconducting) material may be understood as material that exhibits superconducting properties at or below a superconducting critical temperature. Examples of superconducting material include aluminum (superconductive critical temperature of 1.2 kelvin) and niobium (superconducting critical temperature of 9.3 kelvin). Accordingly, superconducting structures, such as superconducting traces and superconducting ground planes, are formed from material that exhibits superconducting properties at or below a superconducting critical temperature.

In certain implementations, control signals for the quantum circuit components (e.g., qubits and qubit couplers) may be provided using classical circuit elements that are electrically and/or electromagnetically coupled to the quantum circuit components. The control signals may be provided in digital and/or analog form.

While this specification contains many specific implementation details, these should not be construed as limitations on the scope of what may be claimed, but rather as descriptions of features that may be specific to particular implementations. Certain features that are described in this specification in the context of separate implementations may also be implemented in combination in a single implementation. Conversely, various features that are described in the context of a single implementation may also be implemented in multiple implementations separately or in any suitable sub-combination.

Moreover, although features may be described above as acting in certain combinations and even initially claimed as such, one or more features from a claimed combination may in some cases be excised from the combination, and the claimed combination may be directed to a sub-combination or variation of a sub-combination.

Particular embodiments of the subject matter have been described. Other embodiments are within the scope of the following claims. For example, the actions recited in the claims may be performed in a different order and still achieve desirable results. As one example, the processes depicted in the accompanying figures do not necessarily require the particular order shown, or sequential order, to achieve desirable results.

## Claims

1. An arrangement comprising:
a plurality of qubits arranged in an at least two-dimensional topology;
a plurality of readout resonators, each qubit of the plurality of qubits arranged to electromagnetically couple to a readout resonator of the plurality of readout resonators;
a first readout transmission line arranged to electromagnetically couple to a first readout resonator group of at least two readout resonators of the plurality of readout resonators,
wherein each readout resonator of the first readout resonator group is arranged to electromagnetically couple to a respective qubit of a first qubit group of at least two qubits of the plurality of qubits; and
a second readout transmission line arranged to electromagnetically couple to a second readout resonator group of at least two readout resonators of the plurality of readout resonators,
wherein each readout resonator of the second readout resonator group is arranged to electromagnetically couple to a respective qubit of a second qubit group of at least two qubits of the plurality of qubits,
wherein the readout resonators of the first readout resonator group and the readout resonators of the first readout resonator group have resonance frequencies from a common readout frequency band,
wherein at least part of the least two qubits of the second qubit group are nearest neighbors of at least part of the least two qubits of the first qubit group, and resonance frequencies of the readout resonators of the first readout resonator group and resonance frequencies of the readout resonators of the second readout resonator group are permuted at least for the nearest neighbors.

2. The arrangement of claim 1, wherein the readout resonators of the first readout resonator group have resonance frequencies from a first resonance frequency band and the readout resonators of the second readout resonator group have resonance frequencies from a second resonance frequency and the first resonance frequency band is overlapping with the second resonance frequency band.

3. The arrangement of any of the preceding claims, wherein resonance frequencies of the readout resonators of the second readout resonator group are permuted at least for the second nearest neighbors.

4. The arrangement of any of the preceding claims, wherein the first qubit group extends along the first readout transmission line, and wherein the second qubit group extends along a second readout transmission line.

5. The arrangement of any of the preceding claims, wherein the first qubit group is at least partially directly adjacent to the second qubit group.

6. The arrangement of any of the preceding claims, wherein at least one qubit of the first qubit group is arranged to electromagnetically couple to at least one qubit of the second qubit group, and
wherein at least one qubit of the second qubit group is arranged to electromagnetically couple to at least one qubit of the first qubit group.

7. A method comprising:
providing a plurality of qubits, a plurality of readout transmission lines, and a plurality of readout resonators,
wherein the plurality of qubits is arranged in an at least two-dimensional topology,
wherein a first readout transmission line is arranged to couple to a first readout resonator group of at least two readout resonators of the plurality of readout resonators, each readout resonator of the first readout resonator group being coupled to a qubit of a first qubit group of at least two qubits of the plurality of qubits, and
wherein a second readout transmission line is arranged to couple to a second readout resonator group of at least two readout resonators of the plurality of readout resonators, each readout resonator of the second readout resonator group being coupled to a qubit of a second qubit group of at least two qubits of the plurality of qubits, and
wherein the readout resonators of the first readout resonator group and the readout resonators of the first readout resonator group have resonance frequencies from a common readout frequency band, and
wherein at least part of the least two qubits of the second qubit group are nearest neighbors of at least part of the least two qubits of the first qubit group, and
resonance frequencies of the readout resonators of the first readout resonator group and resonance frequencies of the readout resonators of the second readout resonator group are permuted at least for the nearest neighbors.

8. The method of claim 7, wherein the first qubit group extends along the first readout transmission line, and wherein the second qubit group extends along the second readout transmission line.

9. The method of claim 7 or 8, comprising: tuning each qubit of the first qubit group to a respective qubit frequency and tuning each qubit of the second qubit group to a respective qubit frequency, wherein qubit frequencies of the qubits of the first qubit group and qubit frequencies of the qubits of the second qubit group are from a common qubit frequency band.

10. The method of any of claims 7 to 9, wherein the readout resonators of the first readout resonator group have resonance frequencies from a first resonance frequency band and the readout resonators of the second readout resonator group have resonance frequencies from a second resonance frequency and the first resonance frequency band is overlapping with the second resonance frequency band.

11. The method of any of claims 7 to 10, comprising measuring a resonance frequency of a readout resonator of the first readout resonator group, and based on the measured resonance frequency, determining a state of a corresponding qubit of the first qubit group to which the readout resonator is coupled.

12. The method of any of claims 7 to 11, wherein at least one qubit of the first qubit group is arranged to electromagnetically couple to at least one qubit of the second qubit group, and
wherein at least one qubit of the second qubit group is arranged to electromagnetically couple to at least one qubit of the first qubit group.

13. The method of any of claims 7 to 12, wherein couplings between a pair of qubits of the first qubit group and the second qubit group have a coupling rate, and wherein a frequency separation between a pair of coupled qubits may be at least ten times the coupling rate, or at least 50 times the coupling rate, or at least 100 times the coupling rate.

14. The method of any of claims 7 to 13, wherein a first unit cell comprises the first qubit group,
wherein a second unit cell comprises the second qubit group, and
wherein a third unit cell comprises a third qubit group of two or more qubits of the plurality of qubits,
the first unit cell, the second unit cell, and the third unit cell being tiled in a first direction to form a unit cell pattern on the two-dimensional topology.

15. The method of claim 14, comprising tuning each qubit of the third qubit group to have a respective qubit frequency within a common qubit frequency band with qubit frequencies of the qubits of the first qubit group and qubit frequencies of the qubits of the second qubit group.
